# FASCICULE DE BREVET EUROPEEN

(11) **EP 2 736 078 B1**
(45) Date de publication et mention de la délivrance du brevet: **10.04.2019**
(21) Numéro de dépôt: 13194316.9
(22) Date de dépôt: 25.11.2013
(51) Int. Cl.: H01L 29/778, H01L 29/10, H01L 29/20

(54) **Transistor bidirectionnel à haute mobilité électronique**
Bidirektionaler Transistor mit hoher Elektronenbeweglichkeit
Bidirectional high electron mobility transistor

(30) Priorité: 26.11.2012 FR 1261252
(43) Date de publication de la demande: 28.05.2014
(73) Titulaire: Commissariat à l'Énergie Atomique et aux Énergies Alternatives, 75015 Paris (FR)
(72) Inventeur: Escoffier, René, 38500 LA BUISSE (FR)
(74) Mandataire: Guérin, Jean-Philippe

(56) Documents cités:
- EP-A1- 0 115 668
- US-A1- 2008 143 421
- US-A1- 2011 275 183

## Description

L'invention concerne les montages de transistors de puissance bidirectionnels utilisés par exemple pour des applications hautes fréquences, et en particulier ceux nécessitant un fonctionnement bidirectionnel basé sur des transistors à haute mobilité électronique.

De nombreuses applications électroniques nécessitent dorénavant un fonctionnement à des fréquences de plus en plus élevées. Ces applications ne sont pas limitées au marché des télécommunications. Des commutateurs dans des gammes de fréquences élevées sont également nécessaires dans l'électronique embarquée à destination de l'automobile et des transports terrestres, dans l'aéronautique, dans les systèmes médicaux ou dans des solutions domotiques par exemple. Ces applications nécessitent pour la plupart des commutateurs sous forte puissance (typiquement entre 500V et plusieurs kilovolts, avec des courants le plus souvent compris entre 10 et 200 A) fonctionnant dans des gammes de fréquences supérieures au megahertz.

Historiquement, des commutateurs hautes fréquences de puissance ont longtemps fait appel à des transistors à effet de champ basés sur un canal semi-conducteur. Pour des fréquences plus faibles, les transistors à jonction (thyristors, ...) sont préférés car ils supportent des densités de courant plus élevées. Cependant, du fait de la tension de claquage relativement limitée de chacun de ces transistors, les applications de puissance nécessitent l'utilisation d'un grand nombre de transistors en série. Les pertes à travers ces transistors en série sont importantes, aussi bien en régime établi qu'en commutation.

Une alternative pour des commutateurs de puissance en hautes fréquences est l'utilisation de transistors à effet de champ à haute mobilité d'électrons (HEMT), également désignés par le terme de transistor à effet de champ à hétérostructure (HFET). Un tel transistor inclut la superposition de deux couches semi-conductrices ayant des bandes interdites différentes formant un puit quantique à leur interface. Des électrons sont confinés dans ce puits quantique pour former un gaz bidimensionnel d'électrons. Pour des raisons de tenue en haute tension et en température, ces transistors seront choisis de façon à présenter une large bande d'énergie interdite.

Parmi les transistors HEMT à large bande d'énergie interdite (usuellement dénommée 'gap' en langue anglaise), les transistors à base de nitrure de gallium sont très prometteurs. Leur largeur de bande d'énergie interdite induit une tension d'avalanche plus haute comparée aux matériaux classiques de l'électronique (Si, SiGe, GaAs, InP), une vitesse élevée de saturation des porteurs et de bonnes stabilités thermique et chimique (permettant une utilisation dans des environnements difficiles). Le champ de claquage du nitrure de gallium (GaN) peut ainsi être supérieur à 3x10⁶ V/cm, ce qui permet aisément de réaliser des transistors avec des tensions de claquage supérieures à 100 V (300 nm de GaN sont suffisants). De plus, de tels transistors permettent de très grandes densités de courant du fait de la très grande mobilité électronique dans le gaz d'interface.

Le nitrure de gallium présente une bande d'énergie interdite large de 3,39eV. De plus, des alliages ternaires tels que du AlGaN ou InGaN peuvent aisément être réalisés à partir d'une machine à former du GaN par épitaxie. Un transistor HEMT à base de nitrure de gallium peut aussi être réalisé sur un substrat en silicium (qui est le substrat de base de l'industrie du semi-conducteur). Le transistor GaN Hemt a donc un coût de production beaucoup plus faible qu'un transistor à base de SiC par exemple. Même si un transistor à base de SiC présente également une large bande d'énergie interdite, des alliages ternaires peuvent difficilement être réalisés à partir de ce matériau, et il ne peut pas être réalisé sur substrat silicium standard, ce qui rend le coût de fabrication prohibitif et en limite fortement les applications.

Le document publié par M. Tatsuo Morita dénommé '650 V 3.1 mΩ.cm2 GaN-based monolithic bidirectional switch using normally-off gate injection transistor' pages 865-868 des publications de la conférence de l'IEEE 'Electron Devices Meeting 2007', décrit un commutateur monolithique bidirectionnel présentant deux transistors AlGaN/GaN de type normalement bloqué, connectés tête-bêches avec drain commun. La commutation de ces transistors est commandée par l'intermédiaire de grilles respectives. La tension de chaque grille est référencée au potentiel de source du transistor correspondant. Par conséquent, les tensions de grille sont référencées à des potentiels différents. Le circuit de commande des grilles est ainsi complexe à réaliser, en particulier pour un tel niveau de fréquence.

Le brevet US7982240 propose une solution pour permettre l'application d'un unique signal de commande sur la grille d'un unique transistor normalement passant. Deux diodes Schottky sont ici connectées en série entre la source et le drain du transistor. Les diodes ont des anodes communes, une cathode est connectée à la source du transistor, l'autre cathode est connectée au drain du transistor. Les fonctions de source et de drain du transistor sont en pratique interverties en fonction du sens d'écoulement du courant. Le noeud de connexion des anodes des diodes fournit un potentiel de référence pour permettre la polarisation de la grille du transistor par rapport à cette référence. Le potentiel de cette référence est modifié en fonction du sens du courant à travers le commutateur.

Cependant, une telle structure présente également des inconvénients. Les diodes doivent être dimensionnées pour des tensions élevées. L'ajout de telles diodes implique l'ajout de masques de gravure lors du procédé de fabrication.

Le document US2008/143421 décrit un transistor de puissance bidirectionnel à hétérojonction à effet de champ. Un circuit de commande génère une tension sur la grille du transistor à partir d'une tension de référence.

L'invention vise à résoudre un ou plusieurs de ces inconvénients. L'invention porte ainsi sur un circuit incluant un transistor de puissance bidirectionnel à hétérojonction à effet de champ tel que défini dans les revendications annexées. L'invention porte également sur un système électrique tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une illustration schématique d'un exemple de transistor de type HEMT selon un exemple de mode de réalisation de l'invention ;
- la figure 2 est une vue de dessus du transistor de la figure 1 ;
- les figures 3 et 4 sont des vues en coupe au niveau de différentes structures d'implants ;
- les figures 5 et 6 sont des diagrammes de profondeurs d'implantation pour un implant en Magnésium dans une couche de GaN.

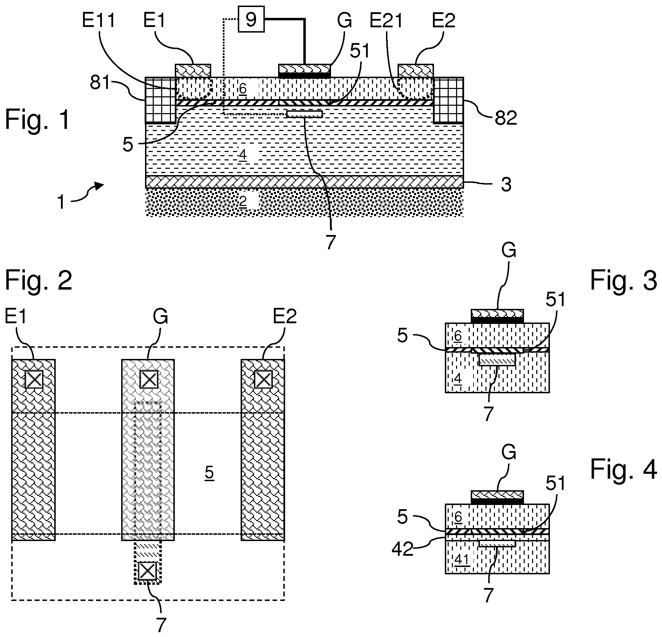

La figure 1 est une vue en coupe transversale schématique d'un exemple de transistor 1 de type HEMT, également désigné par le terme de transistor à effet de champ à haute mobilité d'électrons, ou de transistor à hétérojonction à effet de champ. La figure 2 est une vue de dessus de ce même transistor 1. Le transistor 1 comporte un substrat 2, une couche tampon 3 disposée sur le substrat 2, une couche semi-conductrice 4 (par exemple de type III-V, par exemple en nitrure d'élément III), une couche semi-conductrice 6 en un autre matériau (par exemple de type III-V, par exemple en nitrure d'élément III) et une couche de gaz d'électrons 5 intrinsèquement formée de façon connue en soi à l'interface entre les couches 4 et 6.

Le substrat 2 peut être un isolant ou un semiconducteur de type silicium intrinsèque ou dopé. Le substrat 2 pourra par exemple être de type silicium à orientation de maille (111). Le substrat 2 peut également être du carbure de silicium, ou du saphir. Le substrat 2 peut présenter une épaisseur de l'ordre de 650 µm, typiquement comprise entre 500 µm et 2mm.

La couche tampon 3 déposée sur le substrat 2 sert d'intermédiaire entre ce substrat et la couche de nitrure 4, pour permettre une adaptation de maille entre le substrat 2 et cette couche de nitrure 4. La couche tampon 3 peut typiquement être en nitrure d'aluminium.

La couche de nitrure 4 peut typiquement présenter une épaisseur comprise entre 100nm et 5µm. La couche de nitrure 4 peut être formée de façon connue en soit par épitaxie sur la couche tampon 3. La couche de nitrure 4 est typiquement un alliage binaire de nitrure d'élément III, par exemple du GaN.

La couche de nitrure 6, typiquement appelée couche barrière, peut typiquement présenter une épaisseur comprise entre 5nm et 40nm, par exemple de 25nm. La couche de nitrure 6 peut être formée de façon connue en soit par épitaxie sur la couche de nitrure 4. La couche de nitrure 6 est typiquement un alliage ternaire de nitrure d'élément III, par exemple de l'AlGaN.

Le transistor 1 comporte une première électrode E1 et une deuxième électrode E2, entre lesquelles un courant doit sélectivement être établi. Le transistor 1 doit permettre à la fois l'écoulement du courant de l'électrode E1 vers l'électrode E2, et l'écoulement du courant de l'électrode E2 vers l'électrode E1. Le transistor 1 comporte en outre une grille de commande G, dont le potentiel de commande définit si le transistor 1 est bloqué ou passant. Les électrodes E1 et E2 et la grille G sont ménagées au-dessus de la couche 6. La grille G est ménagée de façon connue en soi sur la couche 6. On peut prévoir que la grille G soit de divers types, par exemple de type Schottky ou MIS (pour Metal Insulated Semiconductors en langue anglaise), sans qu'il soit nécessaire d'altérer la structure du transistor 1.

Afin de favoriser la densité de courant de conduction, les électrodes E1 et E2 peuvent par exemple être connectées à la couche 5 (illustré par les jonctions E11 et E21) de façon connue en soi par diffusion du métal de ces électrodes dans la couche 6 d'une part, et par effet tunnel avec la couche 5 d'autre part. La diffusion dans la couche 6 d'un métal des électrodes E1 et E2 initialement déposé sur cette couche 6 est par exemple réalisée lors d'une étape de recuit. Un tel métal peut être du Ti ou de l'Al, présentant un travail de sortie réduit. Lors du recuit, le Ti réagit par exemple avec du GaN pour former du TiN. Cette réaction extrait des atomes d'azote dans le GaN et génère des vacances d'azote dans la couche de GaN. Ces vacances d'azote agissent comme dopant de type N et créent une région fortement dopée de quelques nm d'épaisseur, formant un contact ohmique par effet tunnel avec la couche 5. La couche 6 peut éventuellement être amincie au niveau des électrodes E1 et E2 par gravure.

La couche 5 comporte une zone 51 à l'aplomb de la grille G. La zone 51 est rendue sélectivement conductrice ou isolante en fonction de la tension appliquée sur la grille G. En fonction de la conception du transistor 1, la zone 51 rend ce transistor soit normalement passant, soit normalement bloqué, en fonction de l'état conducteur ou isolant de la zone 51 en l'absence de polarisation de la grille G. Un circuit de commande 9 applique une tension de polarisation sur la grille G, définie à partir d'une tension de référence. Le transistor 1 est isolé d'autres composants électroniques par l'intermédiaire de tranchées d'isolation 81 et 82.

La grille G est positionnée sensiblement à mi distance entre les électrodes E1 et E2. La grille G est située à une distance de l'électrode E1 comprise entre 45 et 55% de la distance entre les électrodes E1 et E2. La zone 51 se situe donc sensiblement à mi distance entre les électrodes E1 et E2. Un implant de dopants 7 est formé dans la couche 4. L'implant 7 est positionné sensiblement à mi distance entre les électrodes E1 et E2. L'implant 7 est situé à une distance de l'électrode E1 comprise entre 45 et 55% de la distance entre les électrodes E1 et E2. Les distances doivent être considérées relativement au parcours de conduction dans la couche 5. Ainsi, les électrodes E1 et E2 pourraient être physiquement proches mais isolées par une tranchée d'isolation, leur distance de conduction électrique étant alors supérieure à leur distance physique afin de contourner la tranchée d'isolation.

L'implant 7 est avantageusement disposé sous la grille G ou à une distance inférieure à la largeur de grille par rapport à l'aplomb de cette grille G. L'implant 7 est connecté électriquement au circuit de commande 9 par l'intermédiaire d'un connecteur électrique. On peut former un implant 7 relativement fin, par exemple d'une largeur de 500nm, celui-ci n'étant pas destiné à être traversé par un courant.

Le potentiel de l'implant 7 est utilisé comme potentiel de référence pour le circuit de commande 9. Ainsi, avec V7 la tension de l'implant et Vg la tension de la grille G, Vg = V7 + ΔV. Le circuit de commande 9 ajoute ainsi sélectivement un différentiel de tension ΔV en fonction de l'état de conduction souhaité pour le transistor 1. Le différentiel de tension ΔV est ainsi adapté en fonction de la tension de seuil du transistor 1. Comme l'implant 7 est positionné sensiblement à mi distance entre les électrodes E1 et E2, son potentiel est sensiblement égal à V₂₁/2 (avec V₂₁ la différence entre le potentiel de l'électrode E2 et le potentiel de l'électrode E1). Par conséquent, le potentiel de l'implant 7 peut être pris comme potentiel de référence flottant quel que soit le sens du courant entre les électrodes E1 et E2. Ainsi, la commande du transistor 1 est particulièrement simple. L'implant 7 permet par ailleurs d'assurer un meilleur contrôle de la tension de seuil du transistor 1. En outre, le transistor 1 possède alors un fonctionnement bidirectionnel en courant, dans un encombrement réduit, puisque le transistor 1 peut être dépourvu de diodes Schottky de détection de sens du courant contrairement au commutateur décrit dans le brevet US7982240 dans lequel ces diodes doivent être dimensionnées pour résister à la tension appliquée entre les électrodes E1 et E2. Un tel transistor 1 présente en outre un comportement parfaitement symétrique. En outre, la formation de l'implant 7 ne complexifie alors que marginalement le processus de fabrication du transistor 1.

La figure 3 est une vue en coupe schématique d'une première variante au niveau d'un implant 7 s'étendant jusqu'en contact électrique avec la couche 5. L'implant 7 est par exemple réalisé par implantation dans la couche 4, la couche 6 étant ensuite formée par épitaxie sur l'implant 7 et la couche 4. L'implant 7 est au potentiel de la zone 51. La profondeur de la densité maximale d'implantation de dopants de l'implant 7 est par exemple de 30 nm, afin d'une part de ne pas perturber la conduction dans la zone 51, et d'autre part de disposer de la tension de la zone 51 par effet de champ proche. Cette profondeur d'implantation est avantageusement comprise entre 10 et 80 nm, de préférence comprise entre 20 et 60 nm.

Dans cette variante, l'implant 7 est typiquement connecté au circuit de commande 9 par l'intermédiaire d'une entrée haute impédance pour éviter un courant entre l'implant 7 et le circuit de commande 9.

La figure 4 est une vue en coupe schématique d'une deuxième variante au niveau d'un implant 7 séparé de la couche 5. L'implant 7 est ici séparé de la zone 51 par une couche semi-conductrice 42. La couche semi-conductrice 42 est par exemple réalisée par épitaxie, postérieurement à la formation de l'implant 7, sur l'implant 7 et sur une couche semi-conductrice inférieure 41. La couche 4 est ici formée des couches 41 et 42 à base d'un même matériau semi-conducteur. Avec une épaisseur adaptée de la couche 42, par exemple comprise entre 5 et 25nm et de préférence comprise entre 5 et 15nm, l'implant 7 est au potentiel de la zone 51 par effet tunnel.. Il est dans ce cas préférentiel de connecter électriquement l'implant 7 à une entrée haute impédance du circuit de commande 9.

Le choix du type de dopants utilisé pour l'implant 7 pourra être dicté par la facilité d'industrialisation de l'étape d'implantation ou par la facilité d'intégration de cette étape d'implantation dans un procédé de fabrication existant.

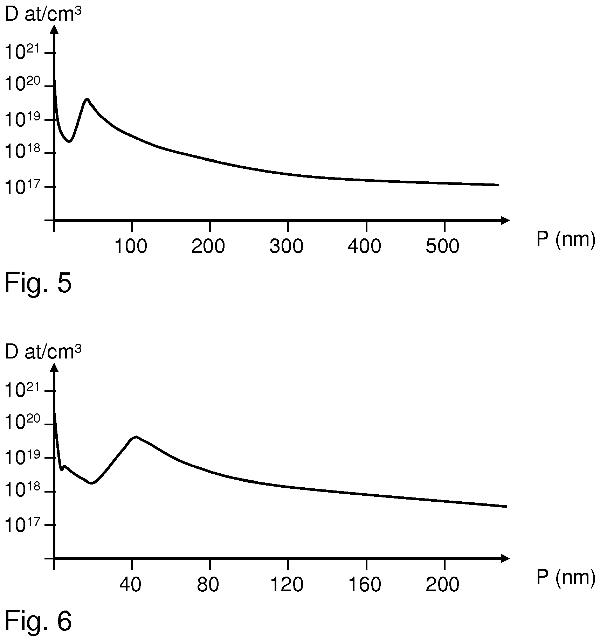

Les figures 5 et 6 sont des diagrammes illustrant la densité de dopants dans l'implant 7 en fonction de la profondeur dans la couche 4. La courbe en trait plein correspond à une implantation de magnésium avec une densité de 1,1*10²⁰ atomes/cm³ dans du GaN. Le magnésium implanté est activé par recuit. On constate une diminution de la densité de 0 à 20 nm de profondeur, une augmentation de la densité entre 20 et 40 nm avec un pic à 40nm, puis une diminution progressive de densité au-delà de 40nm. L'implantation de magnésium est le procédé le plus avantageux, la densité de l'implant étant plus faible jusqu'au pic afin de ne pas créer de champ intrinsèque perturbant la zone 51, tout en présentant une densité suffisante pour assurer la récupération du potentiel de la zone 51 par l'implant 7 par effet tunnel.

Le transistor 1 est typiquement dimensionné pour des applications de puissance, par exemple :
- pour une tension entre les électrodes E1 et E2 supérieure à 100 V, de préférence supérieure à 200 V, et avantageusement pour une tension supérieure à 500 V ;
- pour une intensité entre les électrodes E1 et E2 supérieure à 10 A, de préférence supérieure à 50 A, et avantageusement pour une intensité supérieure à 200 A.

Le transistor 1 peut par exemple être utilisé à des fréquences de commutation supérieures à 1 MHz, voire supérieures à 1 GHz par exemple pour une intégration dans des émetteurs de réseaux de téléphonie mobile.

## Revendications

1. Circuit incluant un transistor de puissance bidirectionnel à hétérojonction à effet de champ (1), **caractérisé en ce que** le transistor comprend :
- des première et deuxième électrodes de conduction (E1, E2) et une grille (G) disposée entre les première et deuxième électrodes de conduction, la distance entre la grille et la première électrode étant comprise entre 45 et 55% de la distance entre les première et deuxième électrodes de conduction ;
- une première couche semiconductrice (4) et une deuxième couche semiconductrice (6) formée sur la première couche semiconductrice (4), les première et deuxième couches semiconductrices (4,6) formant une couche de gaz d'électrons (5) à leur interface ;
- une électrode de référence (7) ménagée dans la première couche semiconductrice (4) et connectée électriquement au potentiel de la zone de la couche de gaz d'électrons (5) située à son aplomb, la distance entre l'électrode de référence et la première électrode de conduction étant comprise entre 45 et 55% de la distance entre les première et deuxième électrodes de conduction ;
- le circuit incluant en outre un circuit de commande (9) connecté à l'électrode de référence (7), le circuit de commande étant programmé pour générer une tension de commande du transistor à partir de la tension de l'électrode de référence et programmé pour appliquer ladite tension de commande sur la grille.

2. Circuit selon la revendication 1, dans lequel ladite électrode de référence (7) est disposée à l'aplomb de la grille (G).

3. Circuit selon la revendication 1 ou 2, dans lequel ladite électrode de référence (7) est disposée à même distance des première et deuxième électrodes de conduction.

4. Circuit selon l'une quelconque des revendications précédentes, dans lequel ladite électrode de référence (7) est un implant de dopants ménagé dans la première couche semi-conductrice (4).

5. Circuit selon la revendication 4, dans lequel la densité maximale de dopants dans l'implant (7) est disposée à une distance comprise entre 10 et 80nm de la couche de gaz d'électrons (5).

6. Circuit selon la revendication 4 ou 5, dans lequel l'implant (7) s'étend dans la profondeur de la première couche semi-conductrice (4) depuis l'interface de celle-ci avec la deuxième couche semi-conductrice (6).

7. Circuit selon la revendication 4 ou 5, dans lequel l'implant (7) est séparé de l'interface entre les première et deuxième couches semi-conductrices par l'intermédiaire d'une couche (42) de semi-conducteur ayant une épaisseur comprise entre 5 et 25nm.

8. Circuit selon l'une quelconque des revendications 4 à 7, dans lequel les dopants de l'implant (7) sont choisis dans le groupe comprenant Mg, Si, Zn, Cr et Fe.

9. Circuit selon l'une quelconque des revendications 4 à 8, dans lequel la densité maximale de dopants dans l'implant (7) est comprise entre 10¹⁸ et 10 ²¹ cm⁻³.

10. Circuit selon l'une quelconque des revendications précédentes, dans lequel la couche de gaz d'électrons (5) s'étend en continu entre les première et deuxième électrodes (E1, E2).

11. Circuit selon l'une quelconque des revendications précédentes, dans lequel la première couche semi-conductrice (41) inclut majoritairement un alliage binaire de nitrure.

12. Circuit selon la revendication 11, dans lequel ledit alliage binaire de nitrure est du GaN.

13. Circuit selon l'une quelconque des revendications précédentes, dans lequel ladite deuxième couche semi-conductrice (6) inclut majoritairement un alliage ternaire de nitrure.

14. Circuit selon la revendication 13, dans lequel ledit alliage ternaire de nitrure est du AlGaN.

15. Système électrique, comprenant :
- un circuit selon l'une quelconque des revendications précédentes ;
- une source de tension configurée pour appliquer une différence de potentiel supérieure à 100V entre les première et deuxième électrodes de conduction du transistor (1).

## Patentansprüche

1. Schaltung, die einen bidirektionalen Leistungstransistor mit Heteroübergang mit Feldeffekt (1) aufweist, **dadurch gekennzeichnet, dass** der Transistor Folgendes umfasst:
- eine erste und eine zweite Leitungselektrode (E1, E2) und ein Gitter (G), das zwischen der ersten und zweiten Leitungselektrode angeordnet ist, wobei der Abstand zwischen dem Gitter und der ersten Elektrode zwischen 45 und 55 % des Abstands zwischen der ersten und zweiten Leitungselektrode liegt;
- eine erste Halbleiterschicht (4) und eine zweite Halbleiterschicht (6), die auf der ersten Halbleiterschicht (4) gebildet ist, wobei die erste und die zweite Halbleiterschicht (4, 6) eine Elektronengasschicht (5) an ihrer Schnittfläche bilden;
- eine Referenzelektrode (7), die in der ersten Halbleiterschicht (4) eingerichtet und elektrisch mit dem Potenzial der Zone der Elektronengasschicht (5) verbunden ist, die zu ihr senkrecht liegt, wobei der Abstand zwischen der Referenzelektrode und der ersten Leitungselektrode zwischen 45 und 55 % des Abstands zwischen der ersten und zweiten Leitungselektrode liegt;
- wobei die Schaltung außerdem eine Steuerschaltung (9) aufweist, die an die Referenzelektrode (7) angeschlossen ist, wobei die Steuerschaltung programmiert ist, um eine Steuerspannung des Transistors ausgehend von der Spannung der Referenzelektrode zu erzeugen, und programmiert ist, um die Steuerspannung auf das Gitter anzulegen.

2. Schaltung nach Anspruch 1, wobei die Referenzelektrode (7) senkrecht zu dem Gitter (G) angeordnet ist.

3. Schaltung nach Anspruch 1 oder 2, wobei die Referenzelektrode (7) an demselben Abstand von der ersten und zweiten Leitungselektrode angeordnet ist.

4. Schaltung nach einem der vorstehenden Ansprüche, wobei die Referenzelektrode (7) ein Implantat von Dotierstoffen ist, das in der ersten Halbleiterschicht (4) eingerichtet ist.

5. Schaltung nach Anspruch 4, wobei die maximale Dichte der Dotierstoffe in dem Implantat (7) an einem Abstand zwischen 10 und 80 nm von der Elektronengasschicht (5) angeordnet ist.

6. Schaltung nach Anspruch 4 oder 5, wobei sich das Implantat (7) in die Tiefe der ersten Halbleiterschicht (4) ausgehend von der Schnittfläche dieser mit der zweiten Halbleiterschicht (6) erstreckt.

7. Schaltung nach Anspruch 4 oder 5, wobei das Implantat (7) von der Schnittfläche zwischen der ersten und zweiten Halbleiterschicht über eine Halbleiterschicht (42), die eine Stärke aufweist, die zwischen 5 und 25 nm liegt, getrennt ist.

8. Schaltung nach einem der Ansprüche 4 bis 7, wobei die Dotierstoffe des Implantats (7) aus der Gruppe ausgewählt sind, die Mg, Si, Zn, Cr und Fe umfasst.

9. Schaltung nach einem der Ansprüche 4 bis 8, wobei die maximale Dichte von Dotierstoffen in dem Implantat (7) zwischen 10¹⁸ und 10²¹ cm⁻³ liegt.

10. Schaltung nach einem der vorstehenden Ansprüche, wobei sich die Elektronengasschicht (5) kontinuierlich zwischen der ersten und zweiten Elektrodenschicht (E1, E2) erstreckt.

11. Schaltung nach einem der vorstehenden Ansprüche, wobei die erste Halbleiterschicht (41) in der Hauptsache eine binäre Nitridlegierung aufweist.

12. Schaltung nach Anspruch 11, wobei die binäre Nitridlegierung GaN ist.

13. Schaltung nach einem der vorstehenden Ansprüche, wobei die zweite Halbleiterschicht (6) in der Hauptsache eine ternäre Nitridlegierung aufweist.

14. Schaltung nach Anspruch 13, wobei die ternäre Nitridlegierung AIGaN ist.

15. Elektrisches System, das Folgendes umfasst:
- eine Schaltung nach einem der vorstehenden Ansprüche;
- eine Spannungsquelle, die konfiguriert ist, um einen Potenzialunterschied größer als 100 V zwischen der ersten und zweiten Leitungselektrode des Transistors (1) anzulegen.

## Claims

1. Circuit including a bidirectional heterojunction field-effect power transistor (1), **characterized in that** the transistor comprises:
- first and second conduction electrodes (E1, E2) and a gate (G) placed between the first and second conduction electrodes, the distance between the gate and the first electrode being comprised between 45 and 55% of the distance between the first and second conduction electrodes;
- a first semiconductor layer (4) and a second semiconductor layer (6) formed on the first semiconductor layer (4), the first and second semiconductor layers (4, 6) forming an electron gas layer (5) at their interface;
- a reference electrode (7) embedded in the first semiconductor layer (4) and electrically connected to the potential of the zone of the electron gas layer (5) located plumb with it, the distance between the reference electrode and the first conduction electrode being comprised between 45 and 55% of the distance between the first and second conduction electrodes,
the circuit further including a control circuit (9) connected to the reference electrode (7), the control circuit being programmed to generate a control voltage for controlling the transistor from the voltage of the reference electrode, and programmed to apply said control voltage to the gate.

2. Circuit according to Claim 1, in which said reference electrode (7) is placed plumb with the gate (G).

3. Circuit according to either of Claims 1 and 2, in which said reference electrode (7) is placed the same distance from the first and second conduction electrodes.

4. Circuit according to any one of the preceding claims, in which said reference electrode (7) is a dopant implant embedded in the first semiconductor layer (4).

5. Circuit according to Claim 4, in which the maximum dopant density in the implant (7) is located a distance comprised between 10 and 80 nm from the electron gas layer (5).

6. Circuit according to either of Claims 4 and 5, in which the implant (7) extends depthwise through the first semiconductor layer (4) from the interface between the latter and the second semiconductor layer (6).

7. Circuit according to either of Claims 4 and 5, in which the implant (7) is separated from the interface between the first and second semiconductor layers by way of a layer (42) of semiconductor having a thickness comprised between 5 and 25 nm.

8. Circuit according to any one of Claims 4 to7, in which the dopants of the implant (7) are chosen from the group comprising Mg, Si, Zn, Cr and Fe.

9. Circuit according to any one of Claims 4 to 8, in which the maximum dopant density in the implant (7) is comprised between 10¹⁸ and 10²¹ cm⁻³.

10. Circuit according to any one of the preceding claims, in which the electron gas layer (5) extends continuously between the first and second electrodes (E1, E2).

11. Circuit according to any one of the preceding claims, in which the first semiconductor layer (41) mainly includes a binary nitride alloy.

12. Circuit according to Claim 11, in which said binary nitride alloy is GaN.

13. Circuit according to any one of the preceding claims, in which said second semiconductor layer (6) mainly includes a ternary nitride alloy.

14. Circuit according to Claim 13, in which said ternary nitride alloy is AIGaN.

15. Electrical system, comprising:
- a circuit according to any one of the preceding claims; and
- a voltage source configured to apply a potential difference higher than 100 V between the first and second conduction electrodes of the transistor (1).
